# FASCICULE DE BREVET EUROPEEN

(11) **EP 2 972 420 B1**
(45) Date de publication et mention de la délivrance du brevet: **03.05.2017**
(21) Numéro de dépôt: 14708568.2
(22) Date de dépôt: 10.03.2014
(51) Int. Cl.: G01R 15/06, H01G 4/02, H02B 7/01, H05K 1/18, H05K 1/02

(54) **ÉLÉMENT RÉSISTIF, MODULE RC ET DIVISEUR EN TENSION RC POUR POSTE ÉLECTRIQUE HAUTE TENSION ISOLÉ PAR UN FLUIDE DIELECTRIQUE**
WIDERSTANDSELEMENT, RC-MODUL UND -SPANNUNGSTEILER FÜR HOCHSPANNUNGSANLAGE ISOLIERT MIT FLÜSSIGEM DIELEKTRIKUM
RESISTIVE ELEMENT, RC MODULE AND VOLTAGE DIVIDER FOR HV SUBSTATION ISOLATED WITH FLUID DIELECTRIC

(30) Priorité: 12.03.2013 FR 1352183
(43) Date de publication de la demande: 20.01.2016
(73) Titulaire: General Electric Technology GmbH, 5400 Baden (CH)
(72) Inventeur: JUGE, Patrice, F-74150 Marcellaz Albanais (FR)
(74) Mandataire: Brevalex
(86) Numéro de dépôt international: PCT/EP2014/054540
(87) Numéro de publication internationale: WO 2014/139924

(56) Documents cités:
- EP-A1- 0 980 003
- WO-A1-2006/015966
- FR-A1- 2 462 713
- US-A1- 2006 012 382

## Description

### DOMAINE TECHNIQUE

L'invention se rapporte au domaine de la mesure de tension et des dispositifs permettant une telle mesure de tension.

La mesure de tension dans les postes électriques à haute tension isolés par un fluide diélectrique fait nécessairement appel à des dispositifs de mesures de tension qui sont adaptés pour tenir la haute tension.

Parmi ces dispositifs, les diviseurs en tension sont particulièrement adaptés par la possibilité d'abaissement de tension qu'ils offrent. De tels diviseurs en tension, lorsqu'ils sont des diviseurs de tension RC sont généralement formés d'éléments résistifs et capacitifs mis en série.

L'invention se rapporte plus précisément à un élément résistif, un module RC et un diviseur de tension RC.

### ÉTAT DE LA TECHNIQUE ANTÉRIEURE

Les diviseurs de tensions destinés équipés des postes électriques à hautes tension qu'ils soient purement résistif ou qu'il soit du type RC, c'est-à-dire résistif-capacitif, sont basés sur l'utilisation d'au moins un module résistif ou RC disposé entre une phase du poste électrique et la masse de ce dernier.

Plus précisément, pour les diviseurs de tension RC, les modules, qui sont donc du type RC, comportent généralement au moins un support céramique disposé entre deux armatures afin de former un condensateur, le support céramique jouant le rôle de l'isolant.

En effet, comme le décrivent les documents FR-2-462-713 et EP-0980-003, chaque module RC comporte un support céramique sur lequel est inscrit au moins un circuit résistif reliant les deux armatures du condensateur qui prennent en sandwich le support céramique. Chaque module forme donc un circuit RC dans lequel le condensateur, formé par les deux armatures, et la résistance, formée par l'au moins un circuit résistif, sont mis en parallèle.

Ces modules, afin de former un diviseur de tension sont mis en série entre l'une des phases, donc la haute tension, et la masse, donc la basse tension, du poste électrique.

Si de tels modules permettent la formation d'un diviseur de tension particulièrement adapté pour les mesures hautes tensions, ils présentent un certain nombre d'inconvénients. En effet, les technologies permettant l'inscription d'un circuit résistif sur une céramique sont particulièrement coûteuses car difficiles à maîtriser. De plus, en raison de l'utilisation de la céramique en tant que support, de tels modules sont lourds et cassants. Il en résulte des contraintes fortes lors du transport de tels modules et une faible tenue aux chocs, tels que ceux qui peuvent être subis lors d'un séisme.

### EXPOSÉ DE L'INVENTION

L'invention a pour objet de résoudre ces inconvénients.

Ainsi l'un des buts de l'invention est de fournir des modules RC à destination des diviseurs de tension RC qui présentent un poids réduit vis-à-vis de modules RC de l'art antérieur.

Un autre but de l'invention est de fournir des modules RC à destination des diviseurs de tension RC qui présentent une sensibilité réduites aux chocs.

A cet effet, l'invention concerne module RC pour diviseur de tension RC à destination d'un poste électrique isolé par un fluide diélectrique, le module RC comprenant un premier et un deuxième support conducteur plan séparés l'un de l'autre afin de former avec le fluide diélectrique, lorsque le module équipe un poste électrique, un condensateur, et le module comprenant au moins un élément résistif reliant électriquement le premier et le deuxième support conducteur, l'élément résistif comprenant un circuit imprimé définissant un circuit électrique résistif comportant une pluralité de dipôles résistifs montés en série.

On entend ci-dessus, et dans le reste de ce document, par circuit imprimé un support adapté pour supporter et connecter électriquement entre eux des composants électroniques discret, tels que des dipôles résistifs et ainsi définir, lorsqu'il est équipé desdits composants, un circuit électrique.

Un module RC comprenant un tel élément résistif placé entre deux plaques conductrices en regard l'une de l'autre permet d'utiliser le fluide diélectrique du poste électrique qu'il équipe en tant qu'isolant du condensateur et ne nécessite donc pas de céramique support. Ainsi, un tel module RC ne présente pas les inconvénients d'un module RC de l'art antérieur qui fait appel à un support céramique.

Un tel module RC est donc particulièrement léger et présente une bonne tenue aux chocs vis-à-vis d'un module RC de l'art antérieur.

On peut également noter qu'avec un tel élément résistif, l'élément résistif peut présenter une forte résistance, ceci malgré l'utilisation de dipôles résistifs présentant une résistance inférieure de plus d'un ordre de grandeur à celle de l'élément d'isolant. Cette possibilité de forte résistance est couplée avec une puissance dissipée par dipôle résistif réduite puisque la puissance dissipée par l'élément résistif est répartie entre les dipôles résistifs.

Le module peut comprendre en outre quatre éléments résistifs montés en parallèle entre le premier et le deuxième support conducteur.

Une telle redondance des éléments résistifs permet de diviser par quatre la puissance à dissiper par chacun des éléments résistifs contrairement à un module RC qui ne comporterait qu'un seul élément résistif. De plus, un tel module RC est particulièrement fiable, puisqu'il peut continuer à fonctionner même avec deux de ces quatre éléments résistifs qui tomberaient en panne.

Le premier et le deuxième support conducteur peuvent être de révolution avec un axe de révolution, les quatre éléments résistifs étant répartis entre le premier et le deuxième support conducteur selon une symétrie axiale.

Une telle configuration des éléments résistifs permet de réduire les problèmes d'homogénéité et de dissymétrie de champ électrique que pourrait engendrer un agencement inadéquat des éléments résistifs.

Les éléments résistifs peuvent s'entrecroiser.

Les éléments résistifs peuvent être agencés sur le module de manière à ce qu'ils forment un angle de 45° avec le plan du premier support.

Un module comportant un tel montage des éléments résistifs est particulièrement adapté pour être disposé dans le diviseur de tension au niveau de la haute tension et est particulièrement compact.

Les éléments résistifs peuvent être sensiblement perpendiculaires au premier et au deuxième support conducteur.

Cette configuration est particulièrement adaptée pour former un module RC dédié à la mesure de tension.

L'invention concerne également un élément résistif pour module RC selon l'invention, ledit élément comprenant un circuit imprimé définissant un circuit électrique résistif comportant une pluralité de dipôles résistifs montés en série.

Un tel élément est particulièrement adapté pour la formation d'un module RC léger et avec une sensibilité réduite aux chocs. En effet, l'élément résistif comprenant un circuit imprimé, il permet de s'affranchir de la nécessité d'un support céramique comme cela est nécessaire dans les modules RC de l'art antérieur.

La pluralité de dipôles résistifs peut comporter une majorité de dipôles discrets et préférentiellement uniquement des dipôles discrets.

Le circuit imprimé peut comporter un support diélectrique sur lequel sont disposées une pluralité de portions de piste conductrice reliées entre elles de manière à former le circuit électrique résistif, au moins deux portions de piste conductrice étant séparées l'une de l'autre par une ouverture aménagée dans le support.

Une telle ouverture est particulièrement avantageuse pour la tenue diélectrique entre les deux portions de piste conductrice séparées par ladite ouverture. En effet, la tenue diélectrique des fluides diélectriques, tels que l'hexafluorure de soufre sous sa forme gazeuse, présent dans les postes électriques isolés par un fluide diélectrique, est généralement significativement supérieure à celle des supports diélectriques de circuits imprimés (par exemple l'époxy présente une tenue diélectrique inférieure de 9 fois celle de l'hexafluorure de soufre sous sa forme gazeuse). Ainsi, il est possible de réduire la distance entre les deux portions de pistes qui sont séparées par l'ouverture et ainsi fournir un élément résistif compact.

Le circuit imprimé peut comporter un support diélectrique sur lequel sont disposées une pluralité de portions de piste conductrice parallèles entre elles et reliées entre elles de manière à former le circuit électrique résistif, deux portions de piste conductrice consécutives étant séparées l'une de l'autre par une ouverture aménagée dans le support.

Le circuit imprimé peut présenter une première et une deuxième face, le circuit électrique résistif passant alternativement de la première à la deuxième face de manière à ce que les dipôles résistifs soient répartis sur chacune des faces du circuit imprimé.

Une telle configuration du module résistif est particulièrement avantageuse pour la tenue diélectrique d'un tel élément résistif et pour sa dissipation thermique. En effet, avec une répartition des dipôles résistifs sur chacune des faces du circuit imprimé, il possible d'adapter le circuit électrique de manière à pratiquement doubler la distance entre les dipôles et donc les pistes du circuit électrique. Ainsi les risques d'arcage entre deux pistes conductrices consécutives sont réduits. De plus cette distance entre les dipôles résistifs permet de réduire le confinement de la chaleur émise par ces derniers en raison de l'effet Joule.

Le circuit résistif sur chacune de la première et de la deuxième face peut être essentiellement formé par des portions de piste conductrice parallèles entre elles le long desquelles sont répartis les dipôles résistifs et qui sont reliées électriquement entre elles par des portions de piste conductrice présentes sur l'autre face dudit circuit imprimé.

On entend ci-dessus par « le circuit électrique est essentiellement formé par des portions de piste conductrice parallèles entre elles » que les portions de piste conductrice parallèles entre elles représentent plus de 50% de la distance linéaire du circuit et préférentiellement 70%, voire 90%. Bien entendu, distance linéaire s'entend par longueur de piste, les dipôles en eux même n'étant pas à prendre en compte dans le calcul de la distance linéaire du circuit.

L'espacement entre lesdites portions de piste conductrice peut être adapté pour limiter les risques d'interaction électrique entre-elles.

Le circuit imprimé peut comporter un support diélectrique adapté pour isoler électriquement une portion de piste conductrice sur la première face d'une portion de piste conductrice sur la seconde face.

Un tel support diélectrique offre une bonne isolation diélectrique entre les portions de piste conductrice qui sont présentes sur une face et celles qui sont présentes sur l'autre face.

Le support diélectrique peut être un support composite verre/ polyépoxydes tel que par exemple en FR4, plus connu sous la dénomination anglaise Flame Resistance 4, c'est-à-dire résistant aux flammes 4.

L'épaisseur du support peut être supérieure ou égale à 3,2 mm.

Le support diélectrique peut être réalisé dans un polymère diélectrique de manière à autoriser une flexion du support et donc de l'élément résistif.

Les dipôles résistifs peuvent être choisis parmi les résistances du type composant montés en surface, les résistances du type composant traversant et des pistes de matériau résistif, tel que le noir de carbone, déposé en surface du circuit imprimé.

L'invention concerne également un module RC pour diviseur de tension RC à destination d'un poste électrique isolé par un fluide diélectrique, le module RC comprenant au moins un élément résistif selon l'invention en parallèle avec un élément capacitif.

Un tel module présente l'avantage d'utiliser le fluide diélectrique du poste électrique qu'il équipe en tant qu'isolant et ne présente donc pas de céramique support. Ainsi un tel module RC ne présente pas les inconvénients d'un module RC de l'art antérieur qui fait appel à un support céramique.

Un tel module RC est particulièrement léger et présente une bonne tenue aux chocs vis-à-vis d'un module RC de l'art antérieur.

L'élément capacitif peut comprendre un premier et deuxième support conducteur plan séparés l'un de l'autre afin de former avec le fluide diélectrique, lorsqu'il équipe un poste électrique, un condensateur, l'élément résistif reliant électriquement le premier et le deuxième support conducteur.

L'invention concerne en outre un ensemble de modules RC comportant une pluralité d'éléments résistifs selon l'invention, deux éléments résistifs successifs étant reliés électriquement entre eux par un support conducteur plan, les liens entre chacun des éléments résistifs et les supports conducteurs plans auxquels il est relié étant pliables de manière à autoriser le placement de deux supports conducteurs consécutifs en regard l'un de l'autre tout en étant parallèles entre eux pour former, avec l'élément résistif les reliant, un module RC selon l'invention.

Un tel ensemble de modules RC permet de former un diviseur de tension particulièrement robuste vis-à-vis des chocs, les liaisons pliables permettant d'absorber une partie de l'énergie potentielle transmise pas de tels chocs.

Chaque élément résistif peut être flexible de manière à autoriser le pliage au niveau du lien entre un élément résistif et l'un des supports conducteurs auxquels il est relié.

Une flexion des éléments résistifs permet d'absorber les mouvements transmis au diviseur de tension soit lors d'un choc, soit en raison de la dilatation thermique de certains éléments du diviseur de tension et/ou de la cuve contenant le diviseur de tension.

L'invention concerne en outre un diviseur de tension destiné à équiper un poste haute tension isolé par un fluide diélectrique, le diviseur de tension comprenant au moins deux modules RC selon l'invention connectés en série entre la masse du poste et une phase de ce même poste.

Un tel diviseur de tension est particulièrement léger et peu sensible aux chocs vis-à-vis d'un diviseur de tension de l'art antérieur.

L'invention concerne également un diviseur de tension destiné à équiper un poste haute tension isolé par un fluide diélectrique, le diviseur de tension comprenant au moins un ensemble de modules selon l'invention, les éléments résistifs et les supports conducteurs étant pliés de manière à ce que deux supports conducteurs consécutifs soient en regard l'un de l'autre tout en tant parallèles entre eux.

Un tel diviseur de tension est particulièrement peu sensible aux chocs vis-à-vis d'un diviseur de tension de l'art antérieur.

Le fluide diélectrique peut être un gaz diélectrique.

Le fluide diélectrique peut être un hexafluorure de soufre SF₆.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- la figure 1 illustre une vue en trois dimensions d'une cuve destinée à équiper un poste électrique isolé au gaz, ladite cuve comportant un diviseur de tension selon l'invention,
- la figure 2 illustre un module RC comportant quatre éléments résistifs, ledit module RC équipant un diviseur de tension selon la figure 1,
- la figure 3 illustre une vue filaire d'un élément résistif équipant un module RC selon la figure 2,
- les figures 4a et 4b illustrent les circuits électriques de la première et de la deuxième face de l'élément résistif illustré sur la figure 3
- la figure 5 illustre un module RC de mesure comportant 4 éléments résistifs selon les figures 3, 4a et 4b, ledit module équipant un diviseur de tension selon la figure 1 au niveau de sa partie qui est en contact avec la basse tension,
- la figure 6 illustre un élément résistif pour module RC d'un diviseur de tension selon un deuxième mode de réalisation de l'invention, cet élément résistif présentant un support avec des ouvertures afin d'améliorer l'isolation entre les portions de piste conductrice successives.
- la figure 7 illustre la répartition de plusieurs diviseurs de tension de manière à équiper chacune des phases d'un poste électrique isolé au gaz,
- la figure 8 illustre un système de centrage d'un diviseur tel qu'illustré sur la figure 1,
- les figures 9a et 9b illustrent un ensemble de modules RC destiné à la formation d'un diviseur de tension selon un deuxième mode de réalisation.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

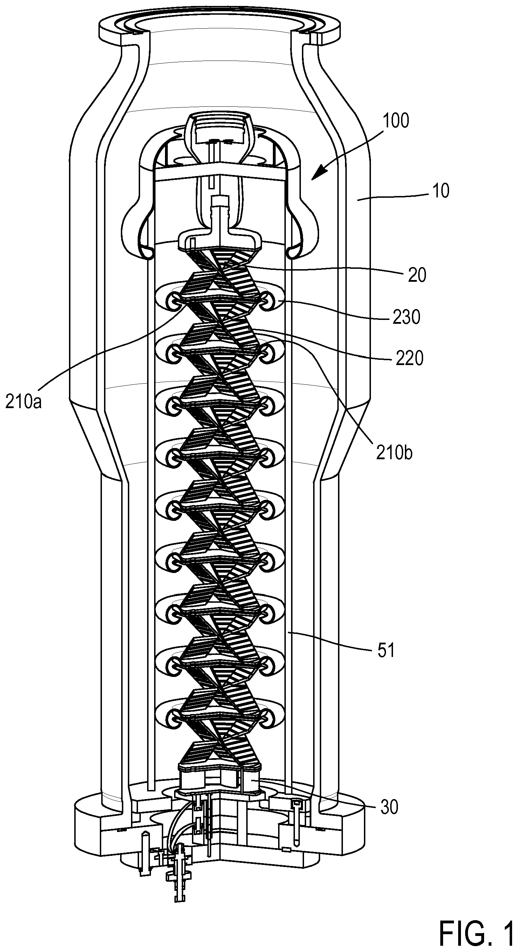

La figure 1 illustre une cuve 10 d'un poste électrique haute tension isolé par un fluide diélectrique, tel que le gaz SF₆, dans laquelle est installé un diviseur de tension RC 100 selon un premier mode de réalisation de l'invention.

Un diviseur tension RC 100 selon l'invention comporte une pluralité de modules RC 20, 30 reliés en série entre une phase du poste haute tension et la basse tension, c'est-à-dire sa masse, de ce même poste.

Le diviseur de tension RC 100 illustré sur la figure 1 comporte ainsi onze modules RC 20 ordinaires et un module RC de mesure 30. Les modules RC 20 ordinaires et le module RC de mesure 30 peuvent être maintenus ensemble au moyen de vis en matériau isolant et d'un système de montant latéraux 51.

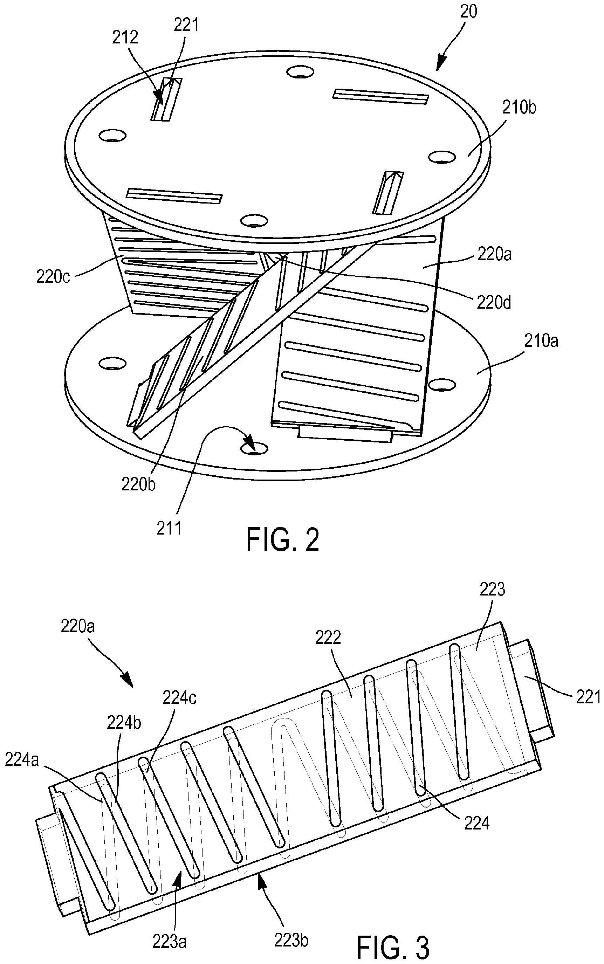

Chaque module RC 20, 30, qu'il soit ordinaire ou de mesure, comporte, comme cela est illustré sur la figure 2, un premier et un deuxième support conducteur plan 210a,b et quatre éléments résistifs 220a,b,c,d.

Les supports conducteurs 210a,b d'un même module RC 20, 30 sont deux supports formés dans un matériau conducteur agencés dans le module RC 20, 30 de manière à former un condensateur plan, le fluide diélectrique du poste à haute tension présent entre les supports conducteurs 210a,b formant l'isolant du condensateur.

Chacun des supports conducteurs 210a,b peut, comme cela est illustré sur la figure 2, prendre la forme d'un disque, ainsi les supports conducteurs 210a,b sont de révolution avec un axe de révolution. Le matériau de chacun des supports conducteurs 210a,b peut être un métal tel que l'acier ou l'aluminium. Les deux supports conducteurs 210a,b d'un même module RC 20, 30 sont agencés dans ce même module RC parallèlement et en regard l'un à l'autre.

Les supports conducteurs 210a,b peuvent également comporter, comme cela est illustré sur la figure 2, des ouvertures 211 afin de limiter les risques de stagnation du fluide entre les deux supports conducteurs 210a,b et ainsi favoriser la convection thermique.

Chacun des supports conducteurs 210a,b comporte quatre systèmes de connexion pour connecter chacun l'un des éléments résistifs du modules RC 20, 30 correspondant. Dans le mode de réalisation illustré sur la figure 2, un tel système de connexion prend la forme d'une fente 212 aménagée sur chaque support conducteur 210a,b pour accueillir une extrémité 221 de l'un des éléments résistifs 220a,b,c,d du module RC 20, 30 correspondant.

Afin d'obtenir une répartition homogène du champ électrique au voisinage des modules RC 20, 30, l'un des supports conducteurs 210a,b de chaque module RC peut être équipé d'un « pare-effluve » qui prend la forme, dans le mode de réalisation illustré sur la figure 1, d'un tube 230 en forme de tore métallique qui vient se placer au niveau de la périphérie de chaque support conducteur 210a,b. Ainsi, les supports conducteurs 210a,b ne présentent pas d'arête susceptible de perturber le champ électrique et de favoriser les phénomènes de décharges partielles.

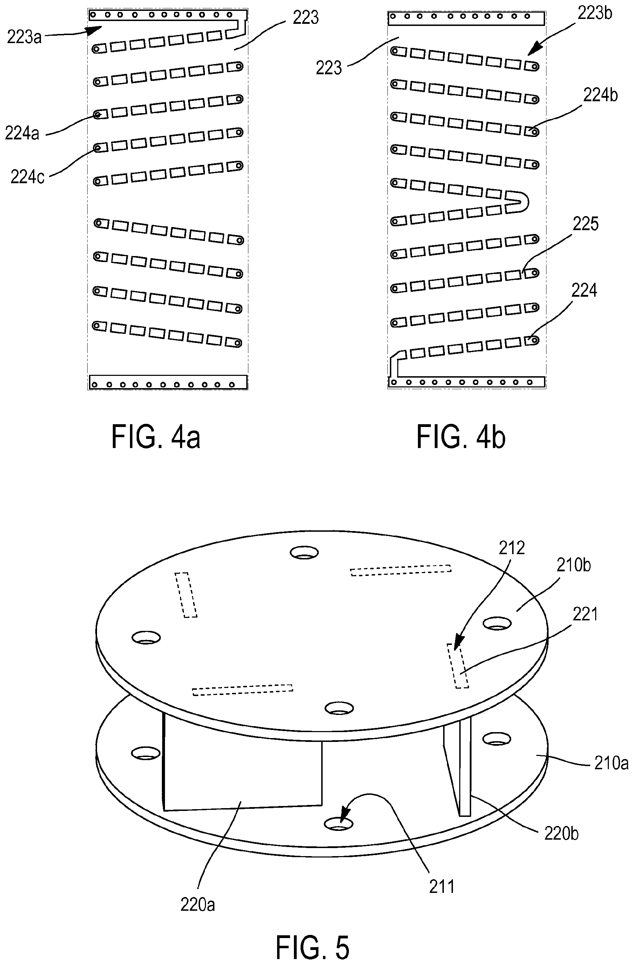

Chaque élément résistif 220a,b,c,d, comme cela est illustré sur les figures 3, 4a et 4b, comporte un circuit imprimé 222 définissant un circuit électrique comportant une pluralité de dipôles résistifs, non figurés.

Les circuits imprimés 222, dans ce premier mode de réalisation, comprennent un support diélectrique 223 plan comportant une piste conductrice 224 qui forme, avec la pluralité de dipôles résistifs, le circuit électrique. Chaque support diélectrique 223 comporte une première et une deuxième face 223a,b. Selon une possibilité de l'invention, les supports diélectriques 223 peuvent être des supports réalisés dans un polyépoxyde, un composite comportant un polyépoxyde ou tout autre substrat isolant électriquement.

Selon cette même possibilité les supports diélectriques 223 peuvent être réalisés dans un composite fibre de verre/ polyépoxyde du type FR4 plus connu sous sa dénomination tissu de verre époxy FR4.

Chaque support diélectrique 223, dans le mode de réalisation illustré sur la figure 3, présente une forme générale plane et parallélépipédique rectangle longitudinale. Chacun des supports diélectriques comporte, au niveau de ses extrémités 223, une excroissance adaptée pour coopérer avec un système de connexion de l'un des supports conducteurs 210a,b du module RC 20, 30 correspondant. L'épaisseur du support diélectrique 223 est adaptée pour limiter les risques de perçage de l'isolant entre deux pistes conductrices se trouvant respectivement sur la première et la deuxième face 223a,b du support diélectrique 223 auxquelles l'on applique une tension d'amplitude similaire à celle qui est appliquée sur l'élément résistif 220a,b,c,d en fonctionnement du diviseur de tension RC 100. Ainsi, dans le cas où le support diélectrique 223 est un support du type FR4, l'épaisseur du support diélectrique 223, dans une configuration usuelle de l'invention, peut être supérieure à 3,2 mm.

Les pistes conductrices 224, selon une configuration avantageuse de l'invention illustrée sur la figure 3, passent alternativement de la première face 223a du support diélectrique 223 correspondant à la deuxième face 223b de ce même support diélectrique 223. Un tel passage alternatif de la première à la deuxième face 223a,b du support diélectrique 223 est obtenu, dans la configuration illustrée sur la figure 3, par des connexions traversantes aménagées dans le support diélectrique 223 correspondant. Une telle configuration est particulièrement avantageuse pour la dissipation thermique des dipôles résistifs, ceux-ci s'en trouvant répartis sur les deux faces du support diélectrique 223.

Les pistes conductrices 224 relient les dipôles résistifs entre eux et permettent la fixation mécanique des dipôles résistifs par soudure. Les pistes conductrices 224 peuvent être réalisées, selon une configuration usuelle des circuits imprimés, en cuivre. Selon cette configuration, afin d'éviter des interactions d'oxydoréduction entre les supports conducteur 210a,b et les pistes conductrices 224, le cuivre peut comporter une finition étamée ou nickel/or. En alternative à des pistes conductrices en cuivre, les pistes conductrices 224 peuvent être réalisées dans un métal autre que le cuivre, tel que l'aluminium, ou un tout autre matériau qui conduit au moins partiellement l'électricité.

Chaque piste conductrice 224 comporte une pluralité de portions 224a,b,c de piste s'étendant sur une face 223a,b de support diélectrique correspondant ceci alternativement sur sa première et sa deuxième face 223a,b. Deux portions de piste 224a,b consécutives sont reliées entre elles par l'une des connexions traversantes. Cette connexion entre les portions de piste 224a,b,c d'une même piste conductrice 224 est réalisée de manière à ce que lesdites portions de piste soient reliées entre elles en série entre les deux extrémités du support diélectrique 223.

Les portions de piste 224a,c qui sont consécutives sur la même face 223a,b d'un support diélectrique 223, afin de limiter les risques d'interactions électriques, telles que des arcages, entre ces dernières, sont généralement sensiblement parallèles entre elles. Cette même particularité est également avantageuse pour la dissipation de l'énergie thermique émise par les dipôles résistifs équipant le circuit électrique. Dans la configuration illustré sur les figures 3, 4a et 4b, afin d'assurer une symétrie du tracé de chacune des pistes conductrices 224, les portions de piste 224a,b,c aux deux extrémités 221 de chacun des supports diélectriques 223 ainsi que celles se trouvant au centre de ce même support diélectrique 223 ne respectent pas cette dernière caractéristique.

Le tracé de chacune des pistes conductrices 224 selon la configuration illustrée sur les figures 3, 4a et 4b est sensiblement en dents de scie. En alternatif à un tel tracé, selon des configurations non illustrées, le tracé de chacune des pistes conductrices 224 peut être selon une forme différente, telle qu'une sinusoïde, ou en créneaux, ceci sans que l'on sorte du cadre de l'invention.

Chacune des portions de piste 224a,b,c est formée par un segment de piste comportant, comme illustré sur les figures 4a et 4b, des discontinuités 225 adaptées chacune pour accueillir un dipôle résistif. Les dipôles résistifs équipent ces discontinuités 225 de manière à ce que chaque dipôle résistif connecte ensemble les deux parties de la portion de piste 224a,b,c correspondante séparée par ladite discontinuité 225. De cette manière, les dipôles résistifs sont montés le long de la piste conductrice 224 correspondante en série et en assurant la continuité électrique de cette dernière.

Dans le mode de réalisation illustré sur la figure 3, les dipôles résistifs sont des résistances du type composant monté en surface également connu sous le sigle CMS. Selon d'autres possibilités alternatives à des résistances du type CMS, les dipôles résistifs peuvent être des résistances standards comportant des broches traversantes ou encore une piste formée d'un matériau résistif tel que le noir de carbone. Selon une configuration usuelle, mais pas nécessaire de l'invention, les dipôles résistifs équipant un élément résistif 220a,b,c,d donné possèdent une résistance sensiblement identique.

Ainsi, la piste conductrice 224 de chaque élément résistif 220a,b,c,d définit un circuit électrique résistif comportant la pluralité de dipôles résistifs montés en série. La résistance d'un élément résistif 220a,b,c,d donné est donc égale à la somme des résistances des dipôles montés le long de sa piste conductrice. De plus, la tension appliquée entre les extrémités dudit élément résistif est donc répartie entre les différents dipôles résistifs. Ainsi, de par ces deux caractéristiques, les éléments résistifs 220a,b,c,d peuvent présenter une forte résistance, ceci malgré l'utilisation de dipôles résistifs présentant une résistance inférieure de plus d'un ordre de grandeur avec une puissance dissipée par dipôle résistif réduite, la puissance dissipée par l'élément résistif 220a,b,c,d étant répartie sur l'ensemble des dipôles résistifs.

Chaque piste conductrice 224, avec les dipôles résistifs qui sont montés le long de cette dernière, forme un circuit électrique résistif.

Les éléments résistifs 220a,b,c,d d'un des modules RC ordinaires 20, comme celui du module RC de mesure 30, comme cela est illustré sur les figures 2 et 5, sont au nombre de quatre. Les éléments résistifs 220a,b,c,d d'un même module RC 20, 30 sont montés entre les deux supports plans, leurs deux extrémités 221 coopérant respectivement avec l'un des systèmes de connexion respectifs du premier et du deuxième support conducteur 210a,b.

Les éléments résistifs 220a,b,c,d sont montés dans un module RC 20,30, les quatre éléments résistifs 220a,b,c,d étant répartis entre le premier et le deuxième support conducteur 210a,b selon une symétrie axiale. Les éléments résistifs 220a,b,c,d d'un même module RC s'entrecroisent. Les éléments résistifs sont agencés sur le module RC de manière à ce qu'ils forment un angle de 45° avec le plan du premier support conducteur 210a.

Selon un exemple de mise en oeuvre de l'invention, les éléments résistifs 220a,b,c,d peuvent prendre la forme d'un support du type FR4 présentant une longueur de 100 mm pour une largeur de 40 mm et une épaisseur de 3,2 mm. La piste conductrice d'un tel élément, en suivant un tracé tel qu'illustré sur les figure 4a et 4b, peut présenter 140 dipôles résistifs. Chaque support conducteur peut présenter un diamètre de 120 mm avec un espace entre les deux supports conducteurs de 80 mm.

Avec des dipôles résistifs adaptés pour dissiper une énergie comprise entre 0,25 W et 1 W et une tenue en tension de 1 000 V, un module RC selon cet exemple de mise en oeuvre et lorsqu'il équipe un poste électrique haute tension isolé à l'hexafluorure de soufre (SF6), présente les caractéristiques suivantes :
- une tension nominale applicable entre les deux supports conducteurs supérieure à 30 000 V,
- une tenue en tension avant claquage supérieure à 100 000 V,
- une dissipation de près de 30 W pour un courant de 1 mA, soit 8 W par éléments résistifs avec chacun des dipôles résistifs qui dissipe en fonctionnement 0,06 W.

De plus, selon cet exemple de mise en oeuvre, lorsque deux des éléments résistifs 220a,b,c,d sont endommagés en étant équivalent à un circuit ouvert, la puissance dissipée par chacun des dipôles résistifs des éléments résistifs 220a,b,c,d non endommagés reste contenue à 0,12 W sans impact significatif sur le fonctionnement du diviseur de tension RC 100.

On peut ainsi voir qu'un seul module RC 20, 30 peut soutenir des valeurs de tension appliquées du même ordre de grandeur que celle existant entre une phase et la masse du poste électrique à haute tension ceci malgré l'utilisation de dipôles résistifs standard.

Le module RC de mesure 30, illustré sur la figure 5, présente un montage des éléments résistifs 220a,b,c,d différent de celui d'un module RC ordinaire 20. Les éléments résistifs 220a,b,c,d du module RC de mesure 30 sont montés dans le module RC de mesure 30 perpendiculairement au premier et au deuxième support 210a,b. Chaque élément résistif 220a,b,c,d du module RC de mesure 30 est monté sensiblement parallèle à élément résistif 220a,b,c,d qui lui est axialement opposé et sensiblement perpendiculaire aux deux autres éléments résistifs 220a,b,c,d.

Chacun des éléments résistifs 220a,b,c,d du module RC de mesure 30 est adapté pour permettre une mesure de tension. Une telle adaptation est obtenue, par exemple, par la présence de connexions électriques en direction de la l'extérieur de la cuve 10 et qui permettent de mesurer la tension aux bornes d'un ou plusieurs dipôles résistifs de l'élément résistif 220a,b,c,d. Ces mêmes éléments résistifs 220a,b,c,d peuvent également comporter des capteurs, tels que des capteurs de température ou de pression afin de connaître les conditions qui règnent dans la cuve et corriger la valeur mesurée en fonction de ces conditions. Le module RC de mesure 30, selon ce même principe, peut également comporter un système de stockage de données, tel qu'une mémoire morte inscriptible ou non, dans laquelle sont indiqués des paramètres permettant de calibrer la mesure en fonction des conditions régnant dans la cuve 10. Un tel système de stockage peut être présent, par exemple, sur chacun des éléments résistifs 220a,b,c,d équipant le module RC de mesure 30.

Le diviseur de tension RC 100 selon l'invention, dans la configuration illustrée sur la figure 1, est relié électriquement à une phase du poste électrique à haute tension par un système de connexion électrique coulissant, ceci de manière à autoriser un déplacement du connecteur qui serrait lié à une dilatation thermique des modules RC 20, 30.

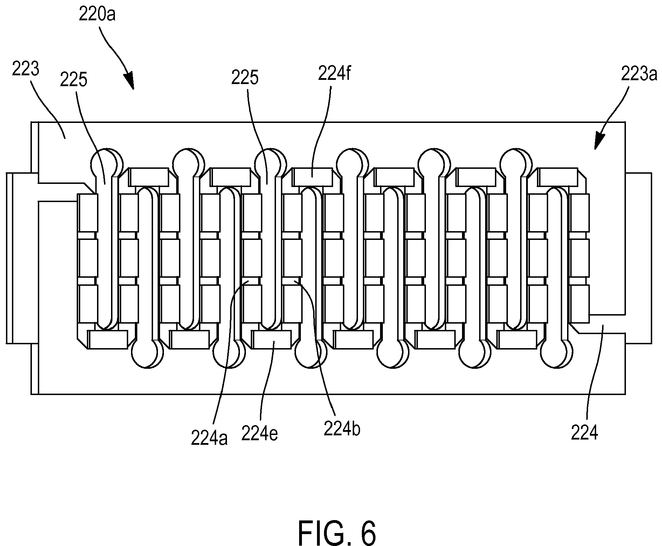

La figure 6 illustre un élément résistif 220a équipant un diviseur de tension 100 selon un deuxième mode de réalisation de l'invention. Un diviseur de tension 100 selon ce deuxième mode de réalisation se différencie d'un diviseur de tension 100 selon le premier mode de réalisation en ce que les modules RC 20, 30 qui composent le diviseur de tension 100 comportent des éléments résistifs 220a dont une partie de la tenue diélectrique est fournie par des ouvertures aménagés dans le circuit imprimé.

Dans ce deuxième mode de réalisation, la piste conductrice s'étend uniquement sur la première face 223a du support diélectrique 223. Les portions de piste 224a,b principales sont sensiblement parallèles entre elles et s'étendent transversalement vis-à-vis de la longueur du support diélectrique 223. Les portions de piste 224a,b principales sont reliées entre elles par des portions de piste secondaires 224e,f qui sont sensiblement parallèles à la longueur du support diélectrique 223. Chacune des pistes conductrices 224a,b principales est séparée de la portion de piste 224a,b principale qui la succède directement le long de la piste conductrice 224 par une ouverture 225 aménagée dans le support diélectrique 223. Les ouvertures 225 du support diélectrique sont des ouvertures traversant sur toute son épaisseur le support diélectrique 233. Chacune des ouvertures 225 s'étend le long des portions de piste 224a,b qu'elle sépare.

Ainsi, avec de telles ouvertures 225, l'élément résistif 220a présente une tenue diélectrique améliorée. En effet, chaque séparation entre deux portions de piste 224a,b consécutives comporte, de par l'aménagement de l'ouverture correspondante, la surface du support isolant avec le fluide diélectrique et le fluide en lui-même. Or, cette surface du support isolant avec le fluide diélectrique est caractérisée par une tenue diélectrique environ trois fois supérieure à celui à l'époxy (communément 3 kV/mm) et environ trois fois inférieure à l'hexafluorure de soufre.

On peut noter que si dans ce deuxième mode de réalisation, la piste conductrice 224, et donc les dipôles résistifs, est répartie sur une seule face du support diélectrique, il est également envisageable, sans que l'on sorte du cadre de l'invention, de répartir la piste conductrice sur les deux faces du support diélectrique. Dans une telle configuration qui n'est pas illustrée, deux portions de piste 224a,b principale qui se succèdent le long de la piste conductrice peuvent être séparées entre elles par une ouverture aménagée dans le support diélectrique. Une telle configuration est particulièrement avantageuse pour la tenue diélectrique et permet une bonne dissipation de la chaleur émise par les dipôles résistifs.

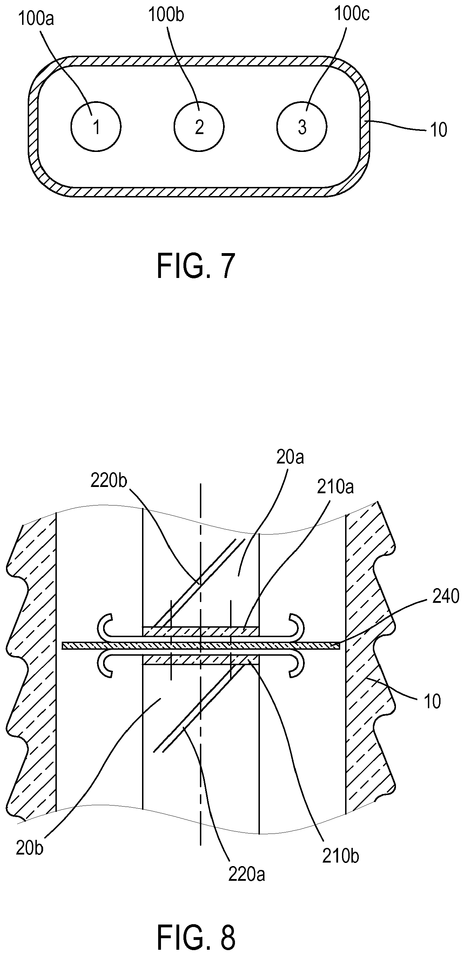

La figure 7 illustre une alternative d'installation d'un diviseur de tension RC 100 selon l'invention dans un poste électrique à haute tension triphasé. Selon cette alternative d'installation, le poste électrique à haute tension comporte trois diviseurs de tension RC 100a,b,c selon l'invention, ces derniers étant installés, comme le montre la section de cuve 10 illustrée sur la figure 5, dans une même cuve 10 qui présente à cet effet une section allongée.

La figure 8 illustre une possibilité alternative et avantageuse de l'invention pour laquelle le pare-effluve 230 est intégré à chaque support conducteur 210a,b et pour laquelle deux modules RC 20a,b successifs dans le diviseur de tension RC 100 sont séparé par une pièce intermédiaire 240 adaptée pour coopérer avec la paroi de la cuve 10 dans lequel le diviseur de tension RC 100 est installé. Une telle pièce intermédiaire 240 fait office de système de centrage du diviseur de tension RC 100.

Selon cette possibilité alternative, afin de ne pas perturber le champ électrique dans la cuve 10 qui dans le cas particulier de la figure 10, est en matériau isolant, la pièce intermédiaire 240 peut être réalisée dans un matériau diélectrique tel qu'un polyépoxyde ou un composite comportant un polyépoxyde.

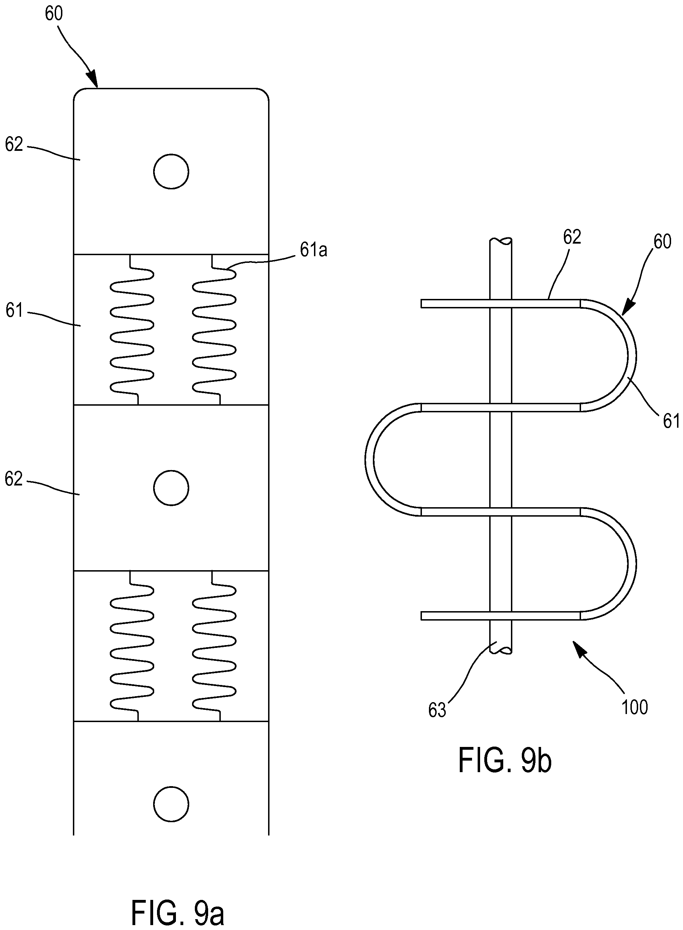

Les figures 9a et 9b illustrent un troisième mode de réalisation de l'invention dans lequel le diviseur de tension RC 100 est formé au moyen d'un ensemble de modules RC 60. Un tel diviseur de tension RC 100 se différencie d'un diviseur de tension RC selon le premier mode de réalisation en ce qu'il est formé au moyen d'un ensemble de modules 60 comportant des éléments résistifs 61 et des supports conducteurs 62, deux éléments résistifs successifs 61 étant reliés entre eux par un support conducteur 62, le lien entre chacun des éléments résistifs 61 et les supports conducteurs 62 auxquels il est relié étant pliable.

La figure 9a illustre l'ensemble de modules 60 en position dépliée. Les supports conducteurs 62 sont, de manière identique à ceux du premier mode de réalisation réalisé dans un matériau conducteur et rigide tel qu'un métal comme l'aluminium ou l'acier. Les supports conducteurs 62, afin de faciliter le pliage et la formation du diviseur de tension, présente une forme carrée.

Les éléments résistifs 61 selon la configuration illustrée sur les figures 9a et 9b sont chacun formés par un circuit imprimé flexible. De tels circuits imprimés flexibles permettent de fournir une liaison flexible avec les supports conducteurs 62 auxquelles ils sont reliés. Ainsi, une telle liaison flexible est pliable. Chaque élément résistif 62 comporte quatre pistes conductrices 224 sur lesquelles sont montés, selon un principe similaire aux éléments résistifs 220a,b,c,d du premier mode de réalisation, des dipôles résistifs. Chacune de ces pistes conductrices 62a forme avec les dipôles résistifs correspondant, un circuit électrique résistif.

La figure 9b illustre le montage de l'ensemble de modules 60 lorsqu'il forme un diviseur de tension 100. Dans un tel montage, l'ensemble de modules 60 est monté de manière à ce que deux supports conducteurs 62 consécutifs soient en regard l'un de l'autre tout en étant parallèles entre eux. Ce montage, dans la configuration illustrée sur la figure 9b est obtenu au moyen d'un axe isolant 63 portant les supports conducteurs 62.

Un diviseur de tension 100 selon ce deuxième mode de réalisation possède l'avantage d'être particulièrement léger vis-à-vis d'un diviseur de tension 100 selon le premier mode de réalisation et de présenter une bonne tenue aux chocs.

## Revendications

1. Module RC (20, 30) pour diviseur de tension RC (100) à destination d'un poste électrique isolé par un fluide diélectrique, comprenant un premier et un deuxième support conducteur (210a,b) plan séparés l'un de l'autre **caractérisé en ce que** le premier et le deuxième support conducteur forment avec le fluide diélectrique, lorsque le module équipe un poste électrique, un condensateur, **et en ce que** le module comprend au moins un élément résistif (220a,b) reliant électriquement le premier et le deuxième support conducteur (210a,b), l'élément résistif comprenant un circuit imprimé (222) définissant un circuit électrique résistif comportant une pluralité de dipôles résistifs montés en série.

2. Module RC (20, 30) selon la revendication 1, comprenant quatre éléments résistifs (220a,b) montés en parallèle entre le premier et le deuxième support conducteur.

3. Module RC (20, 30) selon la revendication 2, dans lequel le premier et le deuxième support conducteur sont de révolution avec un axe de révolution, les quatre éléments résistifs (220a,b,c,d) étant répartis entre le premier et le deuxième support conducteur (210a,b) selon une symétrie axiale.

4. Module RC (20) selon la revendication 2 ou 3, dans lequel les éléments résistifs s'entrecroisent.

5. Module RC (30) selon la revendication 2 ou 3, dans lequel les éléments résistifs sont sensiblement perpendiculaires au premier et au deuxième support.

6. Elément résistif (220a,b,c,d) pour module RC (30) selon l'une quelconque des revendications précédentes, ledit élément (220a,b,c,d) étant **caractérisé en ce qu'**il comprend un circuit imprimé (222) définissant un circuit électrique résistif comportant une pluralité de dipôles résistifs montés en série.

7. Elément résistif (220a,b,c,d) selon la revendication précédente, dans lequel le circuit imprimé comporte un support diélectrique sur lequel sont disposées une pluralité de portions de piste conductrice reliées entre elles de manière à former le circuit électrique résistif, au moins deux portions de piste conductrice étant séparées l'une de l'autre par une ouverture aménagée dans le support.

8. Elément résistif (220a,b,c,d) selon la revendication 6 ou 7, dans lequel le circuit imprimé (222) présente une première et une deuxième face (223a,b), le circuit électrique résistif passant alternativement de la première à la deuxième face (223a,b) de manière à ce que les dipôles résistifs soit répartis sur chacune des faces (223a,b) du circuit imprimé.

9. Elément résistif (220a,b,c,d) selon l'une quelconque des revendications 6 à 8, dans lequel le circuit résistif sur chacune de la première et de la deuxième face (223a,b) est essentiellement formé par des portions de piste conductrice (224a,b,c) parallèles entre elles le long desquelles sont répartis les dipôles résistifs et qui sont reliées électriquement entre elles par des portions de piste conductrice (224a,b,c) présentes sur l'autre face dudit circuit imprimé.

10. Elément résistif (220a,b,c,d) selon l'une quelconque des revendications 6 à 9, dans lequel le circuit imprimé comporte un support diélectrique adapté pour isoler électriquement une portion de piste conductrice (224a,b,c) sur la première face (223a) d'une portion de piste conductrice (224a,b,c) sur la seconde face (223b).

11. Elément résistif (220a,b,c) selon l'une quelconque des revendication 6 à 10, dans lequel les dipôles résistifs sont choisis parmi les résistances du type composant monté en surface, les résistances du type composant traversant et des pistes de matériau résistif, tel que le noir de carbone, déposé en surface du circuit imprimé.

12. Ensemble de modules RC (60) **caractérisé en ce qu'**il comporte une pluralité d'éléments résistifs (61) selon l'une quelconque des revendications 6 à 11, deux éléments résistifs (61) successifs étant reliés électriquement entre eux par un support conducteur (62) plan, les liens entre chacun des éléments résistifs (61) et les supports conducteurs (62) plans auxquels il est relié étant pliables de manière à autoriser le placement de deux supports conducteurs (62) consécutifs en regard l'un de l'autre tout en étant parallèles entre eux pour former, avec l'élément résistif (61) les reliant, un module RC selon la revendication 1.

13. Diviseur de tension (100) destiné à équiper un poste haute tension isolé par un fluide diélectrique, **caractérisé en ce qu'**il comprend au moins deux modules RC (20,30) selon l'une quelconque des revendications 1 à 5 connectés en série entre la masse du poste et une phase de ce même poste.

14. Diviseur de tension (100) destiné à équiper un poste haute tension isolé par un fluide diélectrique, **caractérisé en ce qu'**il comprend au moins un ensemble de modules (60) selon la revendication 12, les éléments résistifs (61) et les supports conducteurs (62) étant pliés de manière à ce que deux supports conducteurs (62) consécutifs soient en regard l'un de l'autre tout en étant parallèles entre eux.

## Patentansprüche

1. RC-Modul (20, 30) für RC-Spannungsteiler (100), der für eine mit flüssigem Dielektrikum isolierte Schaltanlage bestimmt ist, enthaltend
einen ersten und einen zweiten leitfähigen, flachen Träger (210a, b), die voneinander getrennt sind, **dadurch gekennzeichnet, dass** der erste und der zweite leitfähige Träger mit dem flüssigen Dielektrikum dann, wenn das Modul in eine elektrische Schaltanlage eingesetzt ist, einen Kondensator bilden, und dass das Modul zumindest ein Widerstandselement (220a, b) aufweist, das den ersten und den zweiten leitfähigen Träger (210a, b) elektrisch verbindet, wobei das Widerstandselement eine gedruckte Schaltung (222) enthält, die einen resistiven Schaltkreis definiert, der eine Mehrzahl von in Reihe geschalteten, resistiven Dipolen enthält.

2. RC-Modul (20, 30) nach Anspruch 1, enthaltend vier Widerstandselemente (220a, b), die zwischen dem ersten und dem zweiten leitfähigen Träger parallel geschaltet sind.

3. RC-Modul (20, 30) nach Anspruch 2, wobei der erste und der zweite leitfähige Träger mit einer Umlaufachse umlaufend ausgeführt sind, wobei die vier Widerstandselemente (220a, b, c, d) zwischen dem ersten und dem zweiten leitfähigen Träger (210a, b) entlang einer axialen Symmetrie verteilt sind.

4. RC-Modul (20) nach Anspruch 2 oder 3, wobei die Widerstandselemente ineinandergreifen.

5. RC-Modul (30) nach Anspruch 2 oder 3, wobei die Widerstandselemente im Wesentlichen senkrecht zum ersten und zum zweiten Träger verlaufen.

6. Widerstandselement (220a, b, c, d) für ein RC-Modul (30) nach einem der vorangehenden Ansprüche, wobei das Element (220a, b, c, d) **dadurch gekennzeichnet ist, dass** es eine gedruckte Schaltung (222) enthält, die einen resistiven Schaltkreis definiert, der eine Mehrzahl von in Reihe geschalteten resistiven Dipolen enthält.

7. Widerstandselement (220a, b, c, d) nach dem vorangehenden Anspruch, wobei die gedruckte Schaltung einen dielektrischen Träger aufweist, an dem eine Mehrzahl von Leiterbahnenabschnitten angeordnet ist, die so miteinander verbunden sind, dass sie den resistiven Schaltkreis bilden, wobei zumindest zwei Leiterbahnenabschnitte durch eine in den Träger eingebrachte Öffnung voneinander getrennt sind.

8. Widerstandselement (220a, b, c, d) nach Anspruch 6 oder 7, wobei die gedruckte Schaltung (222) eine erste und eine zweite Seite (223a, b) aufweist, wobei der resistive Schaltkreis abwechselnd von der ersten zur zweiten Seite (223a, b) übergeht, so dass die resistiven Dipole auf jeder der Seiten (223a, b) der gedruckten Schaltung verteilt sind.

9. Widerstandselement (220a, b, c, d) nach einem der Ansprüche 6 bis 8, wobei der resistive Schaltkreis auf jeder der ersten und zweiten Seite (223a, b) im Wesentlichen aus Leiterbahnenabschnitten (224a, b, c) gebildet ist, die zueinander parallel verlaufen, entlang derer die resistiven Dipole verteilt sind und die über Leiterbahnenabschnitte (224a, b, c) elektrisch miteinander verbunden sind, die an der anderen Seite der gedruckten Schaltung vorhanden sind.

10. Widerstandselement (220a, b, c, d) nach einem der Ansprüche 6 bis 9, wobei die gedruckte Schaltung einen dielektrischen Träger enthält, der dazu ausgelegt ist, einen Leiterbahnenabschnitt (224a, b, c) auf der ersten Seite (223a) von einem Leiterbahnenabschnitt (224a, b, c) auf der zweiten Seite (223b) elektrisch zu isolieren.

11. Widerstandselement (220a, b, c) nach einem der Ansprüche 6 bis 10, wobei die resistiven Dipole ausgewählt sind aus Widerständen vom Typ oberflächenmontiertes Bauelement, aus Widerständen vom Typ durchgehendes Bauelement und aus Leiterbahnen aus resistivem Material, wie etwa Ruß, der auf die Oberfläche der gedruckten Schaltung aufgebracht ist.

12. Anordnung aus RC-Modulen (60), **dadurch gekennzeichnet, dass** sie eine Mehrzahl von Widerstandselementen (61) nach einem der Ansprüche 6 bis 11 enthält, wobei zwei aufeinanderfolgende Widerstandselemente (61) über einen flachen, leitfähigen Träger (62) elektrisch miteinander verbunden sind, wobei die Verbindungen zwischen jedem der Widerstandselemente (61) und den flachen, leitfähigen Trägern (62), mit denen es verbunden ist, biegbar sind, um das Anordnen von zwei aufeinanderfolgenden, einander gegenüberliegenden, leitfähigen Trägern (62) zu gestatten, die dabei parallel zueinander verlaufen, um mit dem Widerstandselement (61), welche diese verbindet, ein RC-Modul nach Anspruch 1 zu bilden.

13. Spannungsteiler (100), der dazu bestimmt ist, in eine mit einem flüssigen Dielektrikum isolierte Hochspannungsanlage eingesetzt zu werden, **dadurch gekennzeichnet, dass** er zumindest zwei RC-Module (20, 30) nach einem der Ansprüche 1 bis 5 aufweist, die zwischen der Masse der Anlage und einer Phase dieser gleichen Anlage in Reihe geschaltet sind.

14. Spannungsteiler (100), der dazu bestimmt ist, in eine mit einem flüssigen Dielektrikum isolierte Hochspannungsanlage eingesetzt zu werden, **dadurch gekennzeichnet, dass** er zumindest eine Anordnung von Modulen (60) nach Anspruch 12 aufweist, wobei die Widerstandselemente (61) und die leitfähigen Träger (62) so gebogen sind, dass zwei aufeinanderfolgende, leitfähige Träger (62) einander gegenüberliegen und dabei parallel zueinander verlaufen.

## Claims

1. An RC module (20, 30) for an RC voltage divider (100) for an electrical substation insulated by a dielectric fluid comprising first and second plane conductive supports (210a,b) separated from each other, said RC module being **characterized in that** the first and the second conductive support form with the dielectric fluid to a capacitor when the module equips an electrical substation, and **in that** the module further comprises at least one resistive element (220a,b) electrically connecting together the first and the second conductive supports (210a,b), the resistive element comprising a printed circuit (222) defining a resistive electric circuit including a plurality of resistive 2-terminal components mounted in series.

2. An RC module (20, 30) according to claim 1, comprising four resistive elements (220a,b) mounted in parallel between the first and the second conductive supports.

3. An RC module (20, 30) according to claim 2, wherein the first and second conductive supports are circularly symmetrical about an axis of revolution, the four resistive elements (220a,b,c,d) being distributed between the first and the second conductive supports (210a,b) with axial symmetry.

4. An RC module (20) according to claim 2 or claim 3, wherein the resistive elements are crisscrossed.

5. An RC module (30) according to claim 2 or claim 3, wherein the resistive elements are substantially perpendicular to the first and to the second supports.

6. A resistive element (220a,b,c,d) for an RC module (30) according to any preceding claim, said element (220a,b,c,d) being **characterized in that** it comprises a printed circuit (222) defining a resistive electric circuit including a plurality of resistive 2-terminal components mounted in series.

7. A resistive element (220a,b,c,d) according to the preceding claim, in which the printed circuit includes a dielectric support on which a plurality of conductive track portions are disposed that are connected together in such a manner as to form the resistive electric circuit, at least two conductive track portions being separated from each other by an opening provided in the support.

8. A resistive element (220a,b,c,d) according to claim 6 or claim 7, wherein the printed circuit (222) has first and second faces (223a,b), the resistive electric circuit going by turn from the first face (223a) to the second face (223b) in such a manner that the resistive 2-terminal components are distributed over each of the faces (223a,b) of the printed circuit.

9. A resistive element (220a,b,c,d) according to any one of claims 6 to 8, wherein the resistive circuit on each of the first and second faces (223a,b) is essentially formed by conductive track portions (224a,b,c) that are mutually parallel and along which the resistive 2-terminal components are distributed, and that are connected together electrically by conductive track portions (224a,b,c) present on the other face of said printed circuit.

10. A resistive element (220a,b,c,d) according to any one of claims 6 to 9, wherein the printed circuit has a dielectric support adapted to electrically insulate a conductive track portion (224a,b,c) on the first face (223a) from a conductive track portion (224a,b,c) on the second face (223b).

11. A resistive element (220a,b,c) according to any one of claims 6 to 10, wherein the resistive 2-terminal components are chosen from among resistors of the surface-mount component type, resistors of the through-hole component type, and tracks made of resistive material, such as carbon black, deposited on the surface of the printed circuit.

12. A set of RC modules (60), **characterized in that** it includes a plurality of resistive elements (61) according to any one of claims 6 to 11, two successive resistive elements (61) being electrically connected together by a plane conductive support (62), the links between each of the resistive elements (61) and the plane conductive supports (62) to which it is connected being foldable in such a manner as to allow two consecutive conductive supports (62) to be placed facing each other while also being mutually parallel so as to co-operate with the resistive element (61) connecting them together to form an RC module according to claim 1.

13. A voltage divider (100) designed to equip a high-voltage substation insulated by a dielectric fluid, said voltage divider being **characterized in that** it comprises at least two RC modules (20, 30) according to any one of claims 1 to 5, connected together in series between ground of the substation and a phase of the same substation.

14. A voltage divider (100) designed to equip a high-voltage substation insulated by a dielectric fluid, **characterized in that** it comprises at least one set of modules (60) according to claim 12, the resistive elements (61) and the conductive supports (62) being folded in such a manner that two consecutive conductive supports (62) are facing each other while also being mutually parallel.
